# EUROPEAN PATENT APPLICATION

(11) **EP 1 211 721 A1**
(43) Date of publication of application: **05.06.2002**
(21) Application number: 00830796.9
(22) Date of filing: 30.11.2000
(51) Int. Cl.: H01L 21/56

(54) **Improved electronic device package and corresponding manufacturing method**

(71) Applicant: STMicroelectronics S.r.l., 20041 Agrate Brianza (Milano) (IT)
(72) Inventor: Frezza, Giovanni, 00122 Roma (IT)
(74) Representative: Botti, Mario

(57) **Abstract**

A plastic protective package (9) for a semiconductor-integrated electronic device, comprising a support (20) whereon an electronic circuit (30,30a) is placed that can be activated from the outside of said protective package (9), the protective package (9) being provided with a hole or a window (70) at the location of the sensor (30,30a).

## Description

### Application field

This invention relates to an improved protective package for electronic devices, as well as to the corresponding manufacturing method.

Specifically, the invention relates to a plastic protective package for a semiconductor-integrated electronic device, comprising a support on which an electronic circuit and a sensor that can be activated from the outside of said protective package are placed.

The invention also relates to a method for forming a plastic protective package for a semiconductor-integrated electronic device, comprising a sensor that can be activated from the outside of the protective package and is in turn encapsulated in said protective package.

The invention further relates to a mold used for molding a plastic protective package encapsulating an integrated electronic circuit provided with a sensor that can be activated from the outside of said protective package, the mold being formed by a pair of superimposed half-molds defining a space for containing the integrated circuit.

The invention relates, particularly but not exclusively, to a plastic protective package for integrated electronic devices, which is formed with a window so that the contained electronic devices can at least partially be accessed from the outside of the package, and the following description is made with reference to this application field for convenience of illustration only.

### Prior Art

As it is well known, semiconductor electronic devices comprising pressure or optical sensors have grown in demand and gained widespread acceptance in recent years.

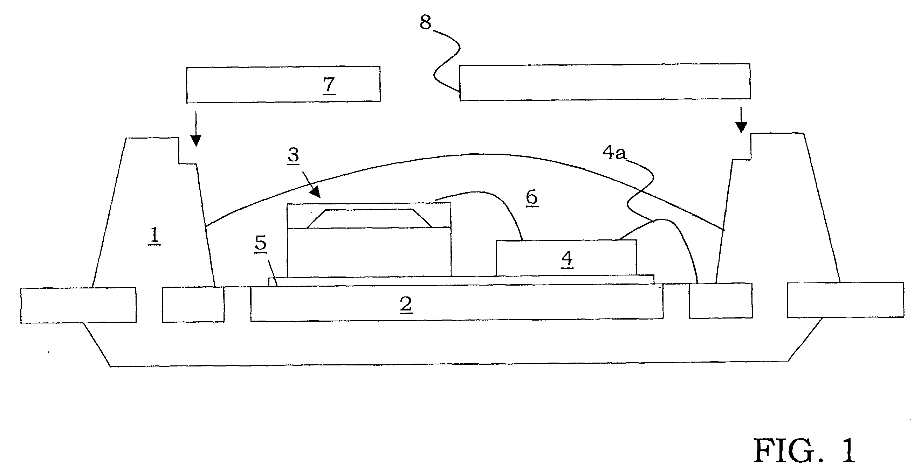

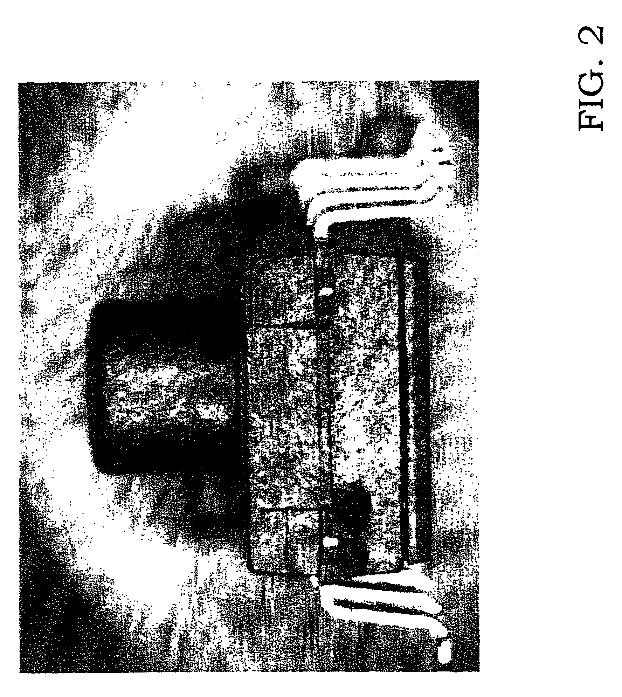

A prior solution for integrating such electronic devices in a package is shown in Figures 1 and 2.

In these figures it is shown, by way of example, a package 1 obtained by a conventional molding technique. This package 1 is substantially tray-like shaped and comprises a support 2 for an integrated circuit.

More particularly, fixed on the support 2 is an integrated circuit comprising a sensor 3, e.g. a proximity or pressure sensor, connected to control circuitry 4. The circuitry 4 is connected to control pins by thin conductor wires 4a for the external electrical connection. Both the sensor 3 and the control circuitry 4 are fixed on the support 2 by means of an epoxy adhesive layer 5.

The sensor 3, the circuitry 4 and the support 2 are covered with a coating gel 6.

The package 1 is closed along its edge by a closing element 7 which may be in the form of a window made out of glass, plastic, or another material.

This closing element 7 has a hole 8 aligned to the sensor 3. A pivot is slidingly inserted through this hole 8 to activate the sensor 3 from the outside of the package.

Although in many ways advantageous, this prior solution has some drawbacks. To complete the device, it is necessary to first build the package, then insert the components into the package, seal the package, and insert the element for operating the sensor through the package window. Also with such devices, the procedure for aligning and positioning the window to insert the element operating the sensor is troublesome, and this makes the device construction difficult to reproduce.

The underlying technical problem of this invention is to provide a package for electronic devices comprising a sensor that can be activated from the outside of the package, which has suitable structural and functional features to enable the package manufacture by conventional molding processes, while overcoming the limitations of the prior art solutions.

The object of this invention is also to provide a mold and a method for making an integrated package comprising sensors that can be activated from the outside of the package.

### Summary of the Invention

The resolutive idea of this invention is to form a package by using a conventional molding technique, and to form it with a window aligned to an integrated electronic device that is housed inside the package, but must communicate with the package exterior. Such a window is obtained by using the same mold that is employed for molding the package, the mold having an internally protruding lug at the sensor location. After having fixed the electronic device and control circuit on the support, a surface of the electronic device is covered with a covering layer made out of elastic material. The support is inserted into the mold such that the protruding lug is aligned to and in contact with the covering layer. The mold is then filled with an insulating material to form the package with its window in a single step.

Based on this resolutive idea, the technical problem is solved by a protective package as previously indicated and defined in the characterizing portion of Claim 1.

The problem is also solved by a method as previously indicated and defined in the characterizing portion of Claim 3.

The problem is further solved by a mold as previously indicated and defined in the characterizing portion of Claim 8.

The features and advantages of the package according to the invention will be apparent from the following description of an embodiment thereof, given by way of example and not of limitation with reference to the accompanying drawings.

### Brief Description of the Drawings

In such drawings:
- Figure 1 is an exploded view schematically showing a protective package for integrated circuits according to the prior art;
- Figure 2 shows a perspective view of a protective package for integrated circuits according to the prior art;
- Figure 3 shows a sectional view of a mold used in molding a protective package for integrated circuits, at the end of the molding processes, according to the invention;
- Figures 4, 5 and 6 are sectional views of embodiments of a plastic protective package at the exit of the mold according to this invention.

### Detailed Description

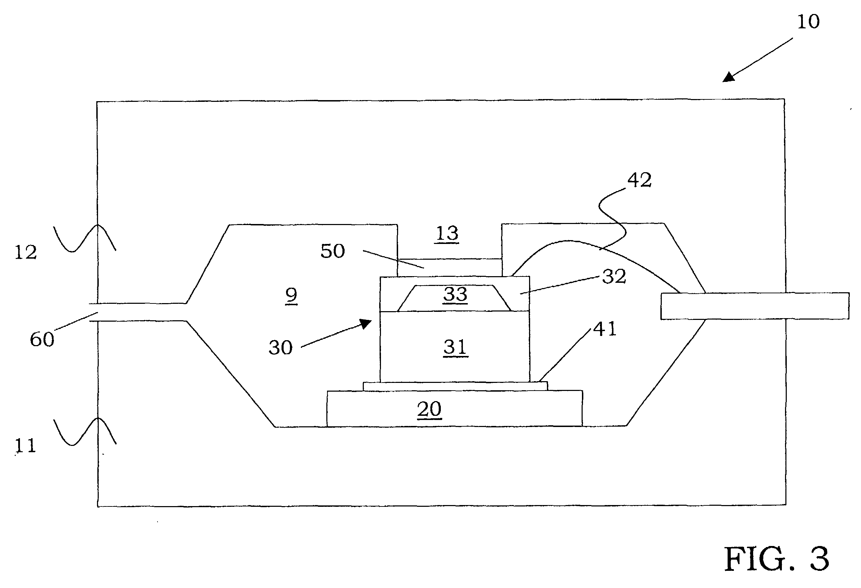

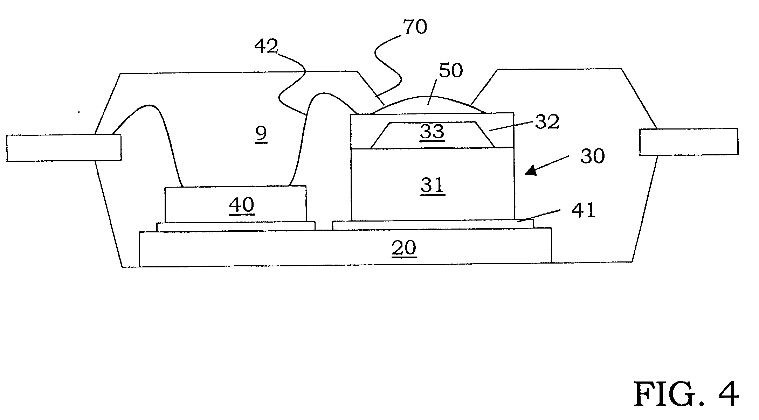

With reference to the drawings, in particular to the examples of Figures 3 and 4, a mold for molding a protective package with a window, according to this invention, is shown at 10. The mold 10 has a cavity for the injection of an insulating material, e.g. a resin.

Figure 3 shows a vertical section of a single mold delimiting a cavity, although in conventional molding techniques the mold includes a plurality of adjacent dies with cavities for simultaneously molding a plurality of packages.

A lead frame or support 20, e.g. in the form of a metal foil, is placed inside the mold cavity. On the lead frame is fixed an electronic circuit comprising an integrated electronic sensor 30, e.g. a proximity sensor of the touch or the optical type.

The following description makes reference to these sensor types. Of course, the invention is also applicable to all electronic devices which, although encapsulated within a protective package, should have a surface portion in communication with the package exterior.

In one embodiment, the sensor 30 may comprise a transparent layer 31, e.g. glass, having a membrane 32 of a semiconductor material laid onto it. This membrane 32 has a concavity arranged to face the pane 31 so as to delimit a recess 33.

Advantageously, the membrane 32 has a substantially flat outward surface.

According to the invention, a covering layer 50 is provided over the membrane 32. This covering layer 50 may consist of a liquid gel, which is subsequently polymerized and made elastic. A suitable material for this layer 50 may be an elastomer.

The mold 10 essentially comprises two parts: a lower half-mold 11 and an upper half-mold 12. When the two half-molds are clamped together, a space is defined for containing the electronic circuit.

According to the invention, the upper half-mold 12 has an internal protruding lug 13 centrally abutting therein, approximately at the location of the sensor 30. This lug 13 is positioned such that, when the half-mold 12 and the lower half-mold 11 are superimposed, the lug 13 will abut against, or at least touch, the sensor covering layer 50.

Advantageously, the lug 13 is substantially cylindrical in shape and has the same dimensions as the covering layer 50.

In an alternative embodiment, the lug 13 may be substantially truncated conical in shape.

Advantageously, the bottom surface of the lug 13 has a smaller area than the top surface of the sensor.

Advantageously, a ring is provided on the cap of the sensor 30, which is formed out of semiconductor material, for example. This ring (not shown) is filled with the covering layer 50 material. Thus, the ring will form a barrage or containing dyke for the covering layer 50.

The method of manufacturing the plastic protective package of this invention will now be described.

Shown at 20 in the figures is a metal support, e.g. a heat sink, on which a die formed with an inner integrated circuit is mounted.

The integrated circuit comprises a sensor 30 which can be activated from the outside of the protective package 9 and is connected to a control circuitry 40. The circuitry 40 is connected to pins by thin conductor wires 42 for external electrical connection.

Advantageously, the support 20 is located on the bottom of the mold cavity, specifically inside the recess formed by the lower half-mold 11.

According to the invention, the surface of the sensor 30 is at least partially coated with a covering layer 50, e.g. a gel comprising an elastomer:

Advantageously, a dyke, e.g. ring-shaped, is formed on the top surface of the sensor 30. The covering layer 50 is then deposited inside this barrier provided by the dyke.

The support 20 is placed into the cavity of the mold 10 according to the invention, and precisely inside the recess of the lower half-mold 11, with the sensor 30 mounted thereon. The pins are laid onto the half-molds 11 outside of the recess.

The upper half-mold 12 is then clamped down onto the lower half-mold 11, so that a containing space is created between the two half-molds 11 and 12 as shown in Figure 3.

When the upper half-mold 12 clamped onto the lower half-mold 11, the lug 13 abuts against the covering layer 50.

According to the invention, the covering layer 50 is to protect the sensor 30 from potential damage by the pressure of the lug 13 against the surface of the sensor 30 when the half-mold 12 is clamped down onto the lower half-mold 11. In fact, the covering layer 50 provides a cushioning effect.

In particular, with the covering layer 50 made out of an elastic material, as the upper half-mold 12 is clamped down onto the lower half-mold 11, the covering layer 50 cedes to the pressure from the lug 13 and prevents cracking of the sensor surface.

Once the two half-molds 11 and 12 are clamped together, the step of forming the protective package 9 is carried out.

A plastic material, such as an epoxy resin, is pressure injected, in a molten state at a high temperature, into cavity between the half-molds through an inlet 60 and runners (not shown).

This is followed by different thermodynamic processes for cooling and curing the resin.

As a result of the lug 13 abutting against the covering layer 50, the package 10 will ultimately show a hole or a window 70 at the location of the sensor 30.

Where the lug 13 is a truncated cone, the window 70 will be formed with tapering walls toward the sensor 30.

Advantageously, the covering layer 50 creates a protective layer over the surface of the sensor 30 after the protective package is completed.

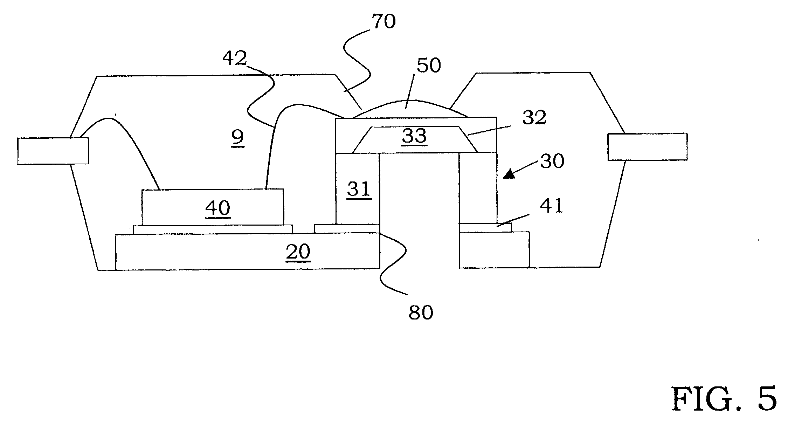

Shown in Figure 5 is a package 9 which has been molded according to the invention in the instance of a pressure sensor 30 being integrated therein.

In this case, both the support 20 and the glass layer 31 of the sensor 30 are formed with a hole 80 that opens into the recess 33 under the membrane 32.

Here again, a package 9 having a window 70 aligned to the sensor 30 can be obtained using a mold 10 according to the invention.

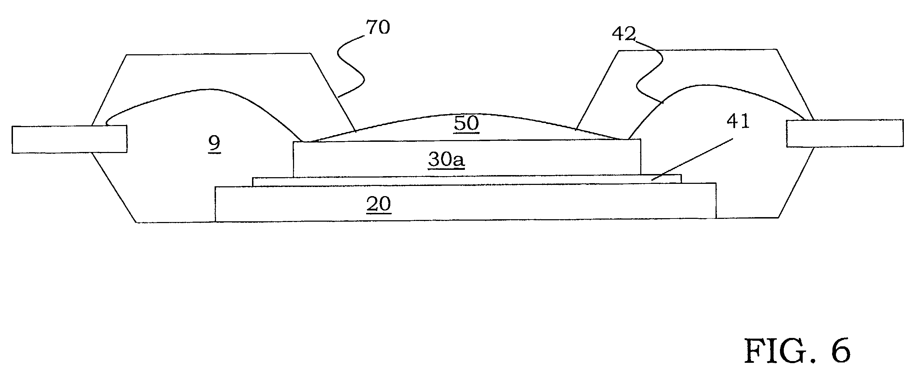

The mold and the method of this invention can also advantageously be used with an integrated circuit provided with optical sensors, as shown in Figure 6.

In this embodiment, an optical sensor 30a is fixed on the support 20. The sensor 30a is coated with a covering layer 50 before the molding step in order to build the protective package 9 according to this invention.

In this embodiment, the covering layer 50 is transparent to UV radiation.

In all these embodiments, the covering layer 50 may be removed from the surface of the sensor 30 after the package 9 is formed.

To conclude, the method and the mold according to the invention allow a plastic protective package, integrated with a sensor that can be activated from the outside of the package, to be manufactured by a conventional molding technique wherein the mold and the manufacturing method have been modified according to the invention.

Electronic devices built with the mold according to this invention allow a more precise manufacturing process, in fact all the steps of aligning the window 70 are carried out during the molding step. Thus, a better reproducibility of the window centring on the device is therefore ensured.

## Claims

1. A plastic protective package (9) for a semiconductor-integrated electronic device, comprising a support (20) whereon an electronic circuit (30,30a) is placed that can be at least partially activated from the outside of said protective package (9); **characterized in that** said protective package (9) is provided with a hole or a window (70) aligned to at least one portion of said integrated circuit (30,30a).

2. A plastic protective package according to Claim 1, **characterized in that** said hole (70) has tapering walls toward said electronic circuit (30,30a).

3. A method for forming a plastic protective package (9) for a semiconductor-integrated electronic device comprising an electronic circuit (30,30a) that can be at least partially activated from the outside of the protective package (9) and that is in its turn intended for being encapsulated in said protective package (9), **characterized by**:
- forming a covering layer (50) on at least a portion of said electronic circuit (30,30a) before the molding step; and
- using a mold (10) comprising a half-mold (11) which has a lug (13) protruding inside the mold and abutting against said covering layer (50) during the molding step, so that said protective package (9) will show a hole (70) aligned to said portion of said electronic circuit (30,30a).

4. A method for forming a plastic protective package (9) according to Claim 3, **characterized in that** said covering layer (50) is formed after a barrier to said covering layer (50) is formed on the electronic circuit (30,30a) sensor (30,30a).

5. A method for forming a plastic protective package (9) according to Claim 3, **characterized in that** said covering layer (50) is made out of elastic material.

6. A method for forming a plastic protective package (9), comprising the following steps:
- placing, into a lower half-mold (11), a support (20) having an integrated circuit (30,30a) thereon which can be activated from the outside of said protective package (9), **characterized in that** it further comprises the steps of:
- forming a covering layer (50) on at least a portion of said electronic circuit (30,30a) before the molding step;
- placing on said lower half-mold (11) an upper half-mold (12) to define a mold cavity, said upper half-mold (10) having a lug (13) protruding inside and abutting against said covering layer (50), so that, after the step of molding said protective package (9), a hole or a window (70) are formed aligned to said covering layer (50).

7. A method for forming package according to Claim 6, **characterized in that** said covering layer (50) is removed after the molding step.

8. A mold (10) for molding a plastic protective package (9) encapsulating an integrated electronic circuit (30,30a) which can be at least partially activated from the outside of said protective package (9), the mold being formed by a pair of superimposed half-molds defining a space for containing the integrated circuit, **characterized in that** one half-mold has a lug (13) protruding approximately at the location of said electronic circuit (30,30a) and abutting against the electronic circuit (30,30a) during the molding step.

9. A mold (10) for molding a plastic protective package (9) according to Claim 8, **characterized in that** a covering layer (50) is interposed between said lug (13) and said electronic circuit (30,30a) during the molding step.

10. A mold (10) for molding a plastic protective package (9) according to Claim 8, **characterized in that** said covering layer (50) covers the integrated circuit.

11. A mold (10) for molding a plastic protective package (9) according to Claim 8, **characterized in that** the lug (13) is cylindrical in shape.

12. A mold (10) for molding a plastic protective package (9) according to Claim 8, **characterized in that** the lug (13) is truncated conical in shape.
